# FASCICULE DE BREVET EUROPEEN

(11) **EP 2 108 191 B1**
(45) Date de publication et mention de la délivrance du brevet: **25.07.2012**
(21) Numéro de dépôt: 08761741.1
(22) Date de dépôt: 07.01.2008
(51) Int. Cl.: H01L 23/473, H05K 7/20, H05K 7/14

(54) **CARTE ELECTRONIQUE ET PLAQUE FROIDE POUR CETTE CARTE**
ELEKTRONISCHE LEITERPLATTE UND KÜHLPLATTE FÜR BESAGTE LEITERPLATTE
ELECTRONIC BOARD AND COLD PLATE FOR SAID BOARD

(30) Priorité: 08.01.2007 FR 0700077
(43) Date de publication de la demande: 14.10.2009
(73) Titulaire: SAMES Technologies, 38240 Meylan (FR)
(72) Inventeur: THOME, Caryl, F-38120 Saint Egreve (FR); ROBERT, Stéphane, F-38240 Meylan (FR)
(74) Mandataire: Myon, Gérard Jean-Pierre
(86) Numéro de dépôt international: PCT/FR2008/000017
(87) Numéro de publication internationale: WO 2008/099085

(56) Documents cités:
- EP-A- 0 844 812
- EP-A- 1 331 665
- WO-A-95/08844
- FR-A- 2 715 773
- FR-A- 2 847 762

## Description

La présente invention concerne une carte électronique et une plaque froide pour refroidir cette carte.

Il existe des cartes électroniques, telles que montrées par exemple dans le document FR 2 715 773, comportant :
- au moins un composant électronique de puissance équipé d'une semelle propre à être directement mise en contact avec un fluide caloporteur,
- une plaque froide sur laquelle est fixée la semelle du composant électronique de puissance de manière étanche au fluide caloporteur, cette plaque froide comportant :
   - au moins un évidement dont une ouverture débouche sous la semelle du composant électronique de puissance,
   - un orifice d'admission du fluide caloporteur à l'intérieur de l'évidement, et
   - un orifice d'évacuation du fluide caloporteur de l'évidement.

Pour ces cartes électroniques, des inserts en plastique sont insérés dans les évidements. Chaque insert comporte plusieurs canaux fluidiquement raccordés d'un côté à l'orifice d'admission et débouchant de l'autre côté à la perpendiculaire de la semelle du composant électronique de puissance. Lors du fonctionnement, chacun de ces canaux produit un jet de fluide caloporteur perpendiculaire à la semelle du composant électronique de puissance pour optimiser l'échange thermique.

La fabrication, et en particulier l'usinage de tels inserts, est compliquée.

L'invention vise à remédier à cet inconvénient en proposant une carte électronique refroidie comme ci-dessus mais plus simple à fabriquer.

L'invention a donc pour objet une carte électronique dans laquelle la plaque froide comporte :
- une plaque plane de projection interposée entre l'orifice d'admission et l'orifice d'évacuation, et
- plusieurs buses rectilignes traversant cette plaque de part en part en suivant une direction de projection, la longueur de la buse le long de la direction de projection étant supérieure ou égale à la plus grande largeur de la buse perpendiculaire à cette même direction pour former un jet de fluide caloporteur le long de la direction de projection, la direction de projection de chaque buse faisant un angle α par rapport à une direction perpendiculaire à la semelle, l'angle α étant compris entre -30 et +30°.

La carte électronique ci-dessus est plus simple à réaliser car la fabrication d'une plaque traversée par des buses est plus simple que la fabrication d'un insert comportant des canaux débouchant directement sur l'orifice d'admission.

L'invention a également pour objet une plaque froide apte à être mise en oeuvre dans la carte électronique ci-dessus.

Les modes de réalisation de cette plaque froide peuvent comporter une ou plusieurs des caractéristiques suivantes :
- chaque buse est formée par un trou traversant la plaque de projection ;
- la direction de projection de chaque buse est perpendiculaire à une face avant ou arrière de la plaque de projection, la face avant de la plaque de projection étant celle tournée vers la semelle et la face arrière étant la face opposée à la face avant, et dans laquelle la plaque de projection est inclinée d'un angle β par rapport au plan de la semelle du composant électronique de puissance, l'angle β étant compris entre -30 et +30° ;
- la plaque froide comporte des conduits propres à faire circuler le fluide caloporteur au travers des orifices d'admission et d'évacuation, ces conduits étant tous disposés dans un même plan parallèle au plan défini par la semelle ;
- la plaque froide comporte :
   - un premier et un second évidements, les premier et second évidements ayant chacun une ouverture débouchant sous la semelle du même premier composant électronique de puissance,
   - au moins un troisième évidement ayant une ouverture débouchant sous la semelle d'un second composant électronique de puissance,
   - l'orifice d'évacuation du premier évidement étant fluidiquement raccordé à l'orifice d'admission du second évidement en passant par les orifices d'admission et d'évacuation du troisième évidement ;
- la plaque froide comporte au moins dix buses agencées les unes par rapport aux autres pour produire des points d'impact des jets de fluide caloporteur uniformément répartis sur la semelle, c'est-à-dire que les distances entre deux points d'impact contigus sont toutes égales les unes aux autres à plus ou moins 15% près.

Ces modes de réalisation de la plaque froide présentent en outre les avantages suivants :
- réaliser les buses par des trous dans la plaque simplifie la réalisation de cette plaque,
- placer les buses perpendiculairement à la face avant ou arrière de la plaque facilite encore plus la réalisation et la fabrication de cette plaque,
- le fait d'avoir la somme des surfaces transversales des buses égale aux surfaces de l'orifice d'admission et de l'orifice d'évacuation, facilite l'écoulement du fluide caloporteur à l'intérieur de la plaque froide,
- le fait de placer les conduits propres à faire circuler le fluide caloporteur à l'intérieur de la plaque froide dans un même plan permet de limiter l'épaisseur de cette plaque froide, et permet également de refroidir la plaque dans toute sa masse, ce qui évacue aussi les calories d'autres composants implantés sur la carte qui ne sont pas en contact direct avec le fluide caloporteur,
- utiliser un premier et un second évidements dont les ouvertures débouchent sous la semelle du même composant électronique de puissance et raccorder ces deux évidements, par l'intermédiaire d'un troisième évidement utilisé pour refroidir un second composant électronique de puissance, permet de réduire les différences de refroidissement des premier et second composants électroniques de puissance par rapport au cas où ces premier et second composants électroniques de puissance seraient refroidis chacun uniquement par un seul évidement, et
- utiliser plus de dix buses permet d'accroître l'efficacité du refroidissement.

L'invention sera mieux comprise à la lecture de la description qui va suivre, donnée uniquement à titre d'exemple non limitatif et faite en se référant aux dessins sur lesquels :
- la figure 1 est une illustration schématique en perspective d'une carte électronique,
- la figure 2 est une illustration schématique en perspective d'une plaque froide utilisée dans la carte de la figure 1,
- la figure 3 est une vue partielle en coupe d'un premier mode de réalisation d'un plaque de projection utilisable dans la plaque froide de la figure 2, et
- les figures 4 et 5 sont des illustrations schématiques, respectivement, d'un deuxième et d'un troisième modes de réalisation d'une plaque de projection utilisable dans la plaque froide de la figure 2.

Dans ces figures, les mêmes références sont utilisées pour désigner les mêmes éléments.

Dans la suite de cette description, les caractéristiques et fonctions bien connues de l'homme du métier ne sont pas décrites en détail.

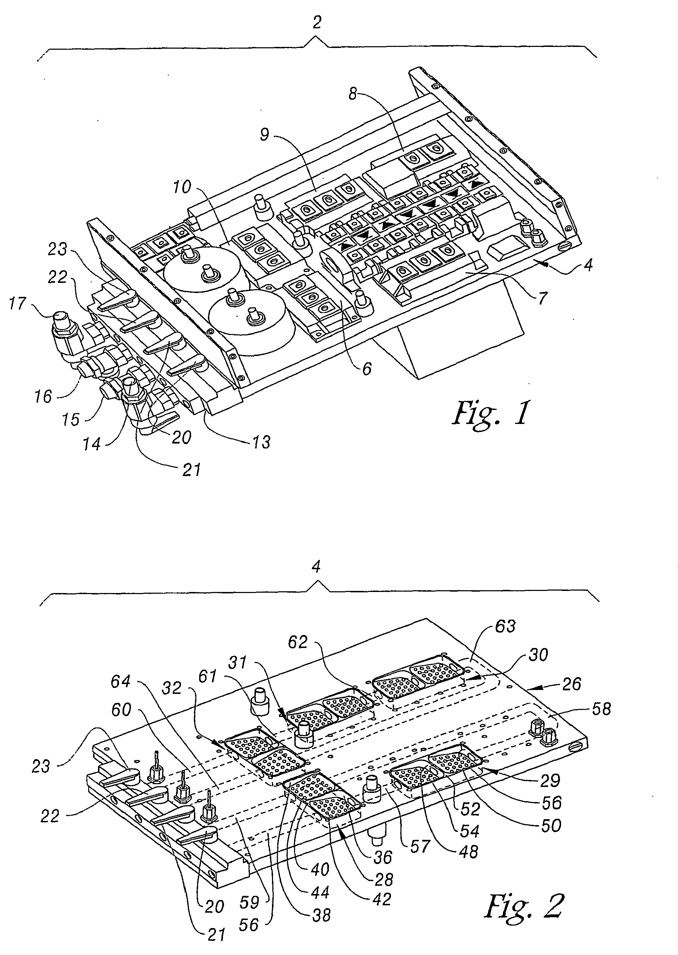

La figure 1 représente une carte électronique 2 équipée de plusieurs composants électroniques de puissance montée sur une plaque froide 4.

Par composant électronique de puissance, on désigne ici des composants susceptibles d'être traversés par des courants alternatifs ou continus de plusieurs dizaines d'ampères sans être détériorés. Typiquement, il s'agit d'interrupteurs aptes à commuter de tels courants..

Ici, la carte 2 comporte cinq interrupteurs de puissance 6 à 10. Ces interrupteurs de puissance sont réalisés à l'aide de transistors IGBT (Insulated Gate Bipolar Transistor). Les autres composants électroniques, montrés sur la figure 1, ne sont pas nécessaires à la compréhension du fonctionnement de la plaque froide et ne sont donc pas décrits ici plus en détail.

La plaque froide 4 présente, sur un bord latéral, un plan de pose 13 propre à recevoir, de façon amovible, quatre raccords 14 à 17 permettant de raccorder fluidiquement la plaque froide 4 à une ou plusieurs sources de fluide caloporteur. Plus précisément, les raccords 14 et 17 sont des raccords amont par lesquels le fluide caloporteur pénètre à l'intérieur de la plaque froide 4. A l'inverse, les raccords 15 et 16 sont des raccords aval par lesquels le fluide caloporteur ressort de la plaque froide 4. Chacun des raccords 14 à 17 est équipé d'une vanne d'isolement propre à empêcher l'écoulement du fluide caloporteur notamment lorsque les raccords 14 à 17 sont désolidarisés du plan de pose 13.

La plaque 4 est ici également équipée de quatre vannes 20 à 23 permettant chacune d'interrompre l'écoulement du fluide pénétrant ou sortant, respectivement, par les raccords 14 à 17.

La plaque froide est destinée à refroidir les différents composants électroniques montés sur celle-ci et en particulier, les composants électroniques de puissance tels que les interrupteurs 6 à 10.

La figure 2 représente plus en détail la plaque froide 4. La plaque froide 4 est formée d'une plaque 26 réalisée dans un matériau thermiquement bon conducteur. Par matériau thermiquement bon conducteur, on désigne ici un matériau dont la conductivité thermique est supérieure à 50W/mK. Par exemple, la plaque 26 est réalisée en aluminium EN AW6082.

La plaque froide 4 comprend également cinq bassins 28 à 32 creusés dans l'épaisseur de la plaque 26. Chacun de ces bassins 28 à 32 débouche uniquement dans la face supérieure de la plaque 26 directement en dessous, respectivement, des interrupteurs 6 à 10. Plus précisément, la périphérie de l'ouverture débouchante de chaque bassin se situe entièrement en dessous de l'interrupteur (IGBT) correspondant lorsque celui-ci est monté sur la plaque froide 4.

Ici, les structures des bassins 28 et 32 sont identiques et ces bassins diffèrent uniquement par leur position dans la plaque 26. De façon similaire, les bassins 29, 30 et 31 ont exactement la même structure et diffèrent uniquement par leur position dans la plaque 26. Ainsi, seule la structure des bassins 28 et 29 est ici décrite plus en détail.

Le bassin 28 est formé de deux évidements 36 et 38 placés l'un à côté de l'autre et séparés l'un de l'autre par une paroi étanche 40. La paroi 40 est conçue pour empêcher que le fluide caloporteur présent dans l'un des évidements puisse passer directement dans l'autre évidement. Ici, les évidements 36 et 38 sont identiques et ont chacun la forme d'un parallélépipède.

A l'intérieur de chacun des évidements 36 et 38 est montée une plaque oblique de projection, respectivement, 42 et 44.

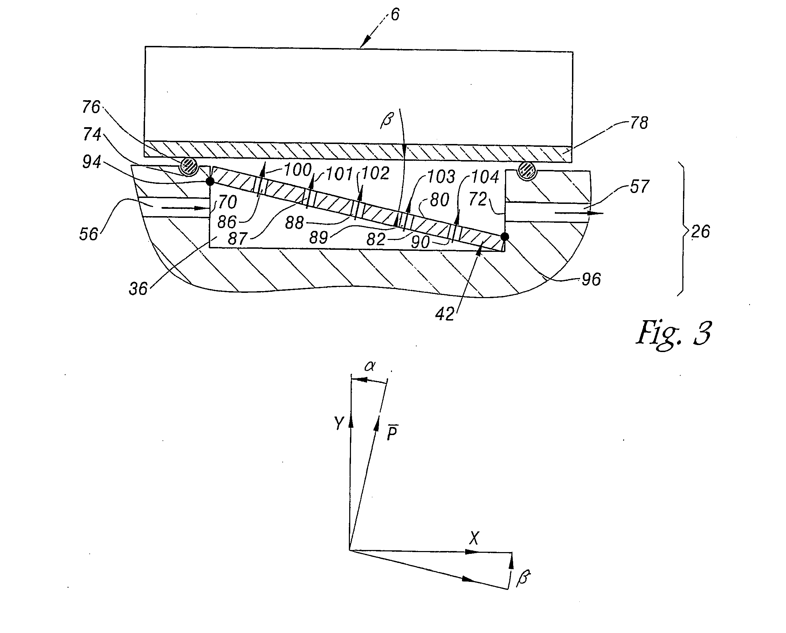

La structure de l'évidement 36 est décrite plus loin en regard de la figure 3.

Le bassin 29 comporte également deux évidements 48 et 50 séparés l'un de l'autre par une paroi 52. Toutefois, contrairement à la paroi 40, ici la paroi 52 est pourvue d'un ou de plusieurs trous permettant de raccorder fluidiquement l'évidement 48 à l'évidement 50.

Les évidements 48 et 50 comportent chacun une plaque oblique de projection, respectivement, 54 et 56. Les structures des évidements et des plaques obliques du bassin 29 sont similaires à celles du bassin 28 et ne seront donc pas décrites ici plus en détail.

La plaque froide comporte un premier circuit de refroidissement des interrupteurs 6 et 7 comportant :
- un conduit 56 raccordant fluidiquement le raccord 14 à l'évidement 36,
- un conduit 57 raccordant fluidiquement l'évidement 36 à l'évidement 48,
- un conduit 58 raccordant fluidiquement l'évidement 50 à l'évidement 38, et
- un conduit 59 raccordant fluidiquement l'évidement 38 au raccord 15.

La plaque froide 4 comprend également un second circuit de circulation d'un fluide caloporteur sous les interrupteurs 8, 9 et 10, ce circuit étant formé :
- d'un conduit 60 raccordant fluidiquement le raccord 17 à l'évidement de gauche du bassin 32,
- d'un conduit 61 raccordant fluidiquement cet évidement de gauche au premier évidement du bassin 31,
- d'un conduit 62 raccordant fluidiquement ce second évidement du bassin 31 au premier évidement du bassin 30,
- d'un conduit 63 raccordant fluidiquement le second évidement du bassin 30 à l'évidement de droite du bassin 32, et
- d'un conduit 64 raccordant fluidiquement l'évidement de droite du bassin 32 au raccord 16.

L'ensemble de ces conduits 56 à 64 sont disposés dans un même plan parallèle à la face supérieure de la plaque 26.

La figure 3 représente plus en détail l'évidement 36 et la plaque 42.

Le conduit 56 débouche à l'intérieur de l'évidement 36 par un orifice 70 d'admission de fluide caloporteur. Après avoir traversé l'évidement 36, le fluide caloporteur s'échappe de l'évidement 36 par l'intermédiaire d'un orifice d'évacuation 72. L'orifice 72 est formé par le conduit 57 qui débouche à l'intérieur de l'évidement 36. Ici, les orifices 70 et 72 sont coaxiaux.

Comme illustré sur la figure 3, l'ouverture du bassin 28 débouchant sur la face supérieure de la plaque 26 est entourée d'une gorge 74. Cette gorge 74 reçoit un joint torique 76. Le joint 76 permet d'assurer l'étanchéité entre une semelle 78 de l'interrupteur 6 et la face supérieure de la plaque 26. Typiquement, la semelle 78 constitue la face inférieure de l'interrupteur 6 et est réalisée dans un matériau thermiquement bon conducteur, tel que le cuivre.

Puisque la semelle 78 recouvre entièrement l'ouverture du bassin 28 débouchant sur la face supérieure de la plaque 26, cette ouverture est hermétiquement close par la semelle 78, de sorte que le fluide caloporteur ne peut pas s'échapper par cette ouverture. On remarquera également que dans ce montage, la semelle 78 est mise directement en contact avec le fluide caloporteur présent dans l'évidement 36.

Sur la figure 3, on a représenté deux directions orthogonales X et Y. La direction Y est perpendiculaire au plan de la semelle 78. La direction X est parallèle au plan de la semelle 78.

La plaque 42 de projection présente une face avant 80 tournée vers la semelle 78 et une face arrière 82 tournée vers l'orifice 70.

Ici, la plaque 42 est transpercée de trous, chaque trou formant ainsi une buse propre à créer un jet de fluide caloporteur venant heurter directement la semelle 78 selon une direction de projection sensiblement perpendiculaire à la semelle 78. Le fait que les jets soient sensiblement perpendiculaires à la semelle 78 accroît l'efficacité du refroidissement. Ici, par sensiblement perpendiculaire à la semelle 78, on entend un jet ayant une direction de projection P formant un angle α compris entre -30 et +30° par rapport à la direction Y. La direction de projection P est représentée par un vecteur P sur la figure 3.

Sur la figure 3, seuls cinq trous 86 à 90 sont représentés. Chacun de ces trous s'étend le long de la direction de projection P. Dans ce mode de réalisation, la direction de projection P est également perpendiculaire aux faces 80 et 82. La plus grande largeur transversale de chacun de ces trous est choisie inférieure ou égale à la longueur du trou le long de la direction P.

De plus, ici, la plus petite largeur de chacun de ces trous est choisie supérieure ou égale à 0,5 millimètres.

Dans ce mode de réalisation, chaque trou a une section transversale circulaire constante. Le diamètre des trous est ici en plus choisi pour que la somme des surfaces transversales des trous soit égale à la surface transversale de l'orifice 70.

La surface de l'orifice 72 est également prise égale à la surface de l'orifice 70.

La section transversale des conduits 56 à 59 est constante.

La plaque 42 est interposée entre l'orifice 70 et l'orifice 72 de manière à ce que plus de 85% du fluide caloporteur traversant l'évidement 36 traverse également les trous formés dans la plaque 42. A cet effet, la plaque 42 est directement en appui avec une paroi amont de l'évidement 36 le long d'une ligne 94 située au-dessus de l'orifice 70. Du côté opposé, la plaque 42 est directement en appui avec une paroi aval de l'évidement 36 le long d'une ligne 96 située en dessous de l'orifice 72. Ici, la plaque 42 est amovible. Par exemple, elle est simplement posée à l'intérieur de l'évidement 36 et maintenue en position par la semelle de la plaque 42 lorsque le fluide caloporteur traverse les trous 86 à 90. Par exemple, la semelle forme une butée pour la plaque de manière à ce que la direction de projection du fluide caloporteur soit maintenue sensiblement perpendiculaire à cette semelle.

Sur la figure 3, les lignes 94 et 96 sont perpendiculaires au plan de la figure et sont donc représentées par des points.

La plaque 42 est également en contact avec la paroi 40 et avec la paroi opposée à cette paroi 40 de l'évidement 36.

Pour que la direction P soit sensiblement perpendiculaire à la semelle 78, ici, le plan de la plaque 42 fait un angle xi par rapport au plan de la semelle 78 compris entre -30 et 0°. Cet angle β est représenté par rapport à la direction X sur la figure 3.

A titre d'exemple, dans ce mode de réalisation, le diamètre de chaque trou est de 3 mm et l'épaisseur de la plaque 42 est également de 3 mm.

Lors du fonctionnement de la plaque froide 4, le fluide caloporteur pénètre à l'intérieur de l'évidement 36 par l'intermédiaire de l'orifice 70. Ensuite, il est projeté sous forme de jets 100 à 104 le long de la direction P. Chacun de ces jets vient heurter directement la semelle 78. Ensuite, après avoir heurté la semelle 78, le fluide caloporteur est évacué par l'intermédiaire de l'orifice 72.

Le fluide évacué de l'évidement 36 est alors conduit par l'intermédiaire du conduit 57 jusqu'à l'évidement 48.

Dans l'évidement 48, de façon similaire à ce qui a été décrit pour l'évidement 36, le fluide est projeté sous forme de jets sensiblement perpendiculaires à la semelle de l'interrupteur 7 avant d'être évacué vers l'évidement 50 par l'intermédiaire du ou des trous réalisés dans la paroi 52.

Dans l'évidement 50, le fluide caloporteur est projeté sous forme de jets sensiblement perpendiculaires à la semelle de l'interrupteur 7, puis évacué par l'intermédiaire du conduit 58 jusqu'à l'évidement 38.

Dans l'évidement 38, le fluide caloporteur est projeté sous forme de jets sensiblement perpendiculaires à la semelle 78 puis évacué par le conduit 59 avant de retourner à la source de fluide caloporteur. La source de fluide caloporteur comprend typiquement une pompe propre à faire circuler à l'intérieur des conduits 56 à 59 le fluide caloporteur.

Etant donné que le fluide froid entre par le raccord 14, la différence de température entre le fluide caloporteur présent dans l'évidement 36 et la semelle 78 est plus importante que la même différence entre le fluide présent dans l'évidement 48 et la semelle de l'interrupteur 7. En fait, au fur et à mesure que le fluide caloporteur progresse à l'intérieur du circuit de refroidissement, celui-ci se réchauffe. Par conséquent, l'efficacité du refroidissement dans l'évidement 36 est élevée et, à l'inverse, relativement faible dans l'évidement 38. On peut également considérer que l'efficacité du refroidissement dans les évidements 48 et 50 est relativement moyenne. On comprend donc qu'en raccordant fluidiquement l'évidement 36 à l'évidement 38 par l'intermédiaire des évidements 48 et 50, on uniformise le refroidissement des interrupteurs 6 et 7. En effet, l'interrupteur 6 est refroidi de façon efficace par l'évidement 36 et de façon relativement moins efficace par l'évidement 38, ce qui correspond en fin de compte à un refroidissement moyennement efficace et donc assez proche de celui que subit l'interrupteur 7. Le fonctionnement des bassins 30 à 32 se déduit du fonctionnement des bassins 28 à 29 qui vient d'être décrit.

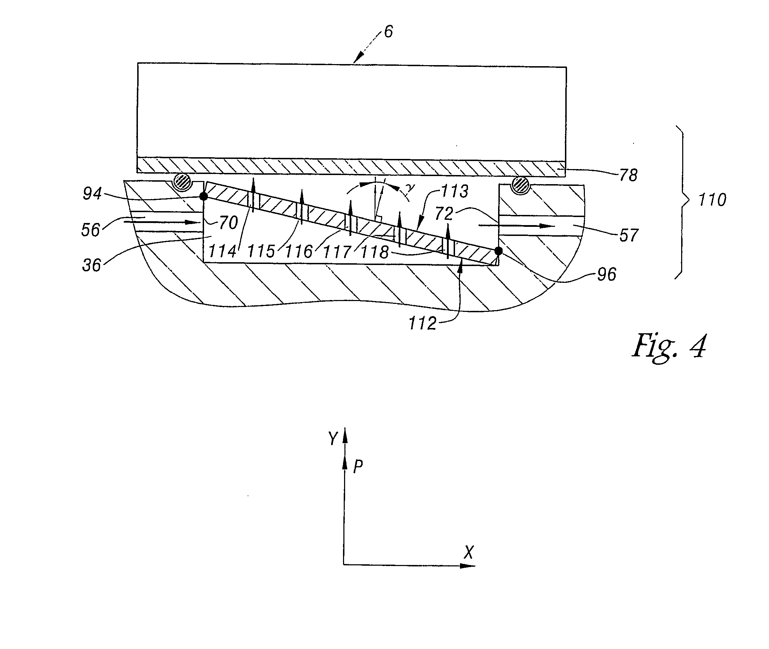

La figure 4 représente un autre mode de réalisation d'une plaque froide 110 identique à la plaque froide 4 à l'exception du fait que la plaque 42 est remplacée par une plaque 112. La plaque 112 est agencée à l'intérieur de l'évidement 36 de façon identique a ce qui a été décrit en regard de la plaque 42. En fait, la plaque 112 diffère de la plaque 42 uniquement par le fait que les trous sont réalisés selon une direction de projection P qui n'est pas perpendiculaire aux faces avant et arrière de la plaque 112. Plus précisément, dans le mode de réalisation de la figure 4, cinq trous 114 à 118 sont représentés. Ces trous 114 à 118 s'étendent le long de la direction de projection P. Dans ce mode de réalisation, la direction de projection P fait un angle γ par rapport à la direction perpendiculaire à la face avant 113. Ici, l'angle γ est pris égal à -β, de sorte que l'angle γ est compris entre -30 et 0°.

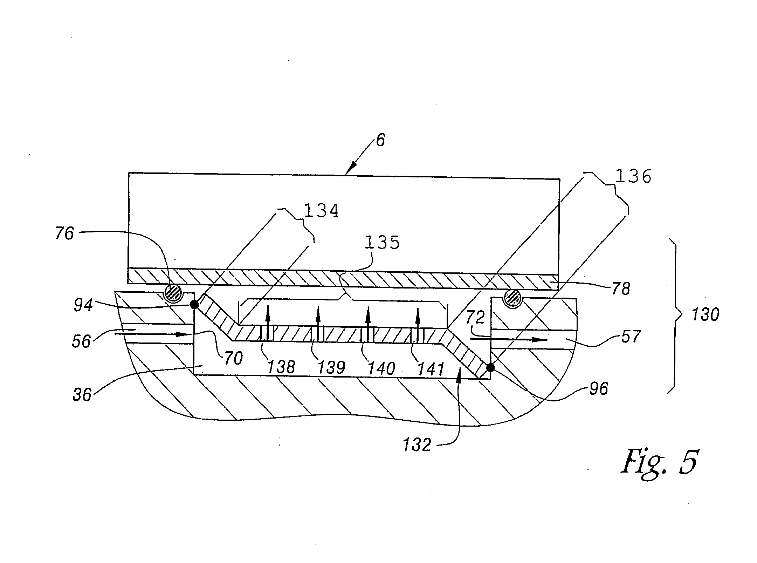

La figure 5 représente un autre mode de réalisation d'une plaque froide 120 identique à la plaque froide 4 à l'exception du fait que la plaque 42 est remplacée par une plaque 132. La plaque 132 diffère de la plaque 42 principalement par le fait que celle-ci n'est pas plane, mais se décompose en trois plans 134 à 136 contigus et raboutés bord à bord.

Le plan 134 est un plan incliné s'étendant de la ligne 94 située au-dessus de l'orifice 70 jusqu'à une position médiane située à mi-hauteur entre la semelle 78 et le fond de l'évidement 36.

Le plan 135 est un plan parallèle à la semelle 78.

Enfin, le plan 136 est un autre plan incliné s'étendant de la position sensiblement médiane jusqu'à la ligne 96 de contact située en dessous de l'orifice 72.

Ici, seul le plan horizontal 135 est transpercé de trous 138 à 141 formant des buses propres à créer un jet de fluide caloporteur perpendiculaire à la semelle 78.

De nombreux autres modes de réalisation sont possibles. Par exemple, le nombre de trous réalisés dans les plaques peut varier. Au minimum il doit y avoir au moins deux trous et de préférence le nombre de trous doit être supérieur à vingt.

En variante, il n'existe qu'un seul évidement en dessous de chaque composant électronique de puissance à refroidir. Ce mode de réalisation est particulièrement indiqué lorsque les raccords d'entrée et de sortie du fluide caloporteur sont situés sur des bords opposés de la plaque 26. A l'inverse, de manière à uniformiser encore plus le refroidissement des différents composants électroniques de puissance, plus de deux évidements peuvent être réalisés en dessous du même composant électronique de puissance..

Typiquement, le fluide caloporteur est de l'eau. Toutefois, celui-ci peut également être de l'huile, un mélange d'eau et d'antigel, ou tout autre fluide caloporteur.

En variante, l'orifice 70 est ménagé sur le fond de l'évidement et non pas sur une paroi latérale. Dans ce mode de réalisation, les angles β et γ sont compris entre -30 et +30°.

La section transversale des trous peut être carrée ou avoir une forme quelconque. En particulier, la section transversale de chaque trou peut aller en rétrécissant au fur et à mesure que l'on avance dans la direction d'écoulement du fluide caloporteur. Dans ce cas, de préférence, c'est la somme des surfaces des plus petites sections transversales des trous qui est égale à la surface transversale de l'orifice 70.

La surface transversale de l'orifice 70 ou de l'orifice 72 n'est pas nécessairement égale à la somme des surfaces transversales des trous ou des buses. Par exemple, la surface transversale de l'orifice 70 ou de l'orifice 72 représente de 20% à 200% de la somme des surfaces transversales des trous.

Plusieurs orifices d'admission et/ou d'évacuation du fluide caloporteur dans un même évidement peuvent être prévus.

Dans les modes de réalisation décrits ici, les trous forment directement les buses de projection sans nécessiter l'ajout de quelconque matière. En variante, des tuyaux formant buses sont enchâssés dans chacun des trous ménagés dans les plaques. Les extrémités de chacun de ces tuyaux peuvent dépasser de part et d'autre des faces avant et arrière de la plaque.

## Revendications

1. Carte électronique comportant :
- au moins un composant électronique (6 à 10) de puissance équipé d'une semelle (78) propre à être directement mise en contact avec un fluide caloporteur,
- une plaque froide (4) sur laquelle est fixée la semelle (78) du composant électronique de puissance de manière étanche au fluide caloporteur, cette plaque froide comportant :
• au moins un évidement (36, 38, 48, 50) dont une ouverture débouche sous la semelle du composant électronique (6 à 10) de puissance,
• au moins un orifice (70) d'admission du fluide caloporteur à l'intérieur de l'évidement, et
• au moins un orifice (72) d'évacuation du fluide caloporteur de l'évidement,
**caractérisée en ce que** la plaque froide (4) comporte également :
- une plaque (42 ; 112) de projection interposée entre l'orifice (70) d'admission et l'orifice (72) d'évacuation, et
- plusieurs buses rectilignes (86 à 90 ; 114 à 118) traversant cette plaque de part en part en suivant une direction de projection, la longueur de la buse le long de la direction de projection étant supérieure ou égale à la plus grande largeur de la buse perpendiculaire à cette même direction pour former un jet (100 à 104) de fluide caloporteur le long de la direction de projection, la direction de projection de chaque buse faisant un angle α par rapport à une direction perpendiculaire à la semelle, l'angle α étant compris entre -30 et +30°.

2. Plaque froide destinée à supporter des composants électroniques de puissance équipés d'une semelle apte à être directement mise en contact avec un fluide caloporteur, la semelle de ces composants électroniques de puissance étant fixés sur la plaque froide de manière étanche au fluide caloporteur, cette plaque froide comportant :
• au moins un évidement (36, 38, 48, 50) dont une ouverture débouche sous la semelle du composant électronique (6 à 10) de puissance,
• au moins un orifice (70) d'admission du fluide caloporteur à l'intérieur de l'évidement, et
• au moins un orifice (72) d'évacuation du fluide caloporteur de l'évidement,
**caractérisée en ce que** la plaque froide comporte :
- une plaque (42 ; 112) de projection interposée entre l'orifice (70) d'admission et l'orifice (72) d'évacuation, et
- plusieurs buses rectilignes (86 à 90 ; 114 à 118) traversant cette plaque de part en part en suivant une direction de projection, la longueur de la buse le long de la direction de projection étant supérieure ou égale à la plus grande largeur de la buse perpendiculaire à cette même direction pour former un jet (100 à 104) de fluide caloporteur le long de la direction de projection, la direction de projection de chaque buse faisant un angle α par rapport à une direction perpendiculaire à la semelle, l'angle α étant compris entre -30 et +30°.

3. Plaque froide selon la revendication 2, dans laquelle chaque buse (86 à 90 ; 114 à 118) est formée par un trou traversant la plaque de projection (42).

4. Plaque froide selon la revendication 2 ou 3, dans laquelle la plaque de projection est plane et dans laquelle la direction de projection de chaque buse est perpendiculaire à une face avant (80) ou arrière (82) de la plaque de projection, la face avant de la plaque de projection étant celle tournée vers la semelle et la face arrière étant la face opposée à la face avant, et dans laquelle la plaque de projection (42) est inclinée d'un angle β par rapport au plan de la semelle du composant électronique de puissance, l'angle β étant compris entre - 30 et +30°.

5. Plaque froide selon l'une quelconque des revendications 2 à 4, dans laquelle la plaque froide comporte des conduits (56 à 64) propres à faire circuler le fluide caloporteur au travers des orifices d'admission (70) et d'évacuation (72), ces conduits étant tous disposés dans un même plan parallèle au plan défini par la semelle.

6. Plaque selon l'une quelconque des revendications 2 à 5, dans laquelle la plaque froide comporte :
• un premier et un second évidements (36, 38), les premier et second évidements ayant chacun une ouverture débouchant sous la semelle du même premier composant électronique (6) de puissance,
• au moins un troisième évidement (48, 50) ayant une ouverture débouchant sous la semelle d'un second composant électronique (7) de puissance,
• l'orifice d'évacuation (72) du premier évidement (36) étant fluidiquement raccordé à l'orifice d'admission du second évidement (38) en passant par les orifices d'admission et d'évacuation du troisième évidement (48, 50).

7. Plaque selon l'une quelconque des revendications 2 à 6, dans laquelle la plaque froide comporte au moins dix buses (86 à 90 ; 114 à 118) agencées les unes par rapport aux autres pour produire des points d'impact des jets (100 à 104) de fluide caloporteur uniformément répartis sur la semelle, c'est-à-dire que les distances entre deux points d'impact contigus sont toutes égales les unes aux autres à plus ou moins 15% près.

## Claims

1. An electronic circuit card including:
■ at least one electronic power component (6 to 10) fitted with a soleplate (78) suitable for being put directly into contact with a cooling fluid;
■ a cold plate (4) having the soleplate (78) of the electronic power component fastened thereon in a manner that is leaktight relative to the cooling fluid, the cold plate including:
■ at least one recess (36, 38, 48, 50) including an opening that opens out under the soleplate of the electronic power component (6 to 10);
■ at least one admission orifice (70) for admitting cooling fluid into the inside of the recess; and
■ at least one discharge orifice (72) for discharging cooling fluid from the recess;
the card being **characterized in that** the cold plate (4) also comprises:
■ a spray plate (42; 112) interposed between the admission orifice (70) and the discharge orifice (72); and
■ a plurality of rectilinear nozzles (86 to 90; 114 to 118) passing right through said plate in a spray direction, the length of the nozzle along the spray direction being longer than or equal to the greatest width of the nozzle perpendicular to said direction so as to form a jet (100 to 104) of cooling fluid along the spray direction, the spray direction of each nozzle being at an angle α relative to a direction perpendicular to the soleplate, the angle α lying in the range -30° to +30°.

2. A cold plate for supporting electronic power components each fitted with a soleplate suitable for being put directly into contact with a cooling fluid, the soleplate of the electronic power components being fastened on the cold plate in a manner that is leaktight relative to the cooling fluid, said cold plate including:
■ at least one recess (36, 38, 48, 50) including an opening that opens out under the soleplate of the electronic power component (6 to 10);
■ at least one admission orifice (70) for admitting cooling fluid into the inside of the recess; and
■ at least one discharge orifice (72) for discharging cooling fluid from the recess;
the cold plate being **characterized in that** it includes:
■ a spray plate (42; 112) interposed between the admission orifice (70) and the discharge orifice (72); and
■ a plurality of rectilinear nozzles (86 to 90; 114 to 11B) passing right through said plate in a spray direction, the length of the nozzle along the spray direction being longer than or equal to the greatest width of the nozzle perpendicular to said direction so as to form a jet (100 to 104) of cooling fluid along the spray direction, the spray direction of each nozzle being at an angle α relative to a direction perpendicular to the soleplate, the angle α lying in the range -30° to +30°.

3. A cold plate according to claim 2, wherein each nozzle (86 to 90; 114 to 118) is formed by a hole passing through the spray plate (42).

4. A cold plate according to claim 2 or claim 3, wherein the spray plate is plane, and wherein the spray direction of each nozzle is perpendicular to the front or rear face (80, 82) of the spray plate, the front face of the spray plate being the face facing towards the soleplate, and the rear face being the face opposite from the front face, and wherein the spray plate (42) is inclined at an angle β relative to the plane of the soleplate of the electronic power component, the angle β lying in the range -30° to +30°.

5. A cold plate according to any one of claims 2 to 4, wherein the cold plate includes ducts (56 to 64) suitable for enabling the cooling fluid to flow through the admission and discharge orifices (70, 72), said ducts all being disposed in a common plane parallel to the plane defined by the soleplate.

6. A cold plate according to any one of claims 2 to 5, wherein the cold plate includes:
■ first and second recesses (36, 38), the first and second recesses each having an opening opening out under the soleplate of a common first electronic power component (6);
■ at least one third recess (48, 50) having an opening opening out under the soleplate of a second electronic power component (7); and
■ the discharge orifice (72) of the first recess (36) being in fluid flow connection with the admission orifice of the second recess (38), passing via the admission and discharge orifices of the third recess (48, 50).

7. A cold plate according to any one of claims 2 to 6, wherein the cold plate includes at least ten nozzles (86 to 90; 114 to 118) arranged relative to one another so as to produce jets (100 to 104) of cooling fluid having impact points that are uniformly distributed over the soleplate, i.e. the distances between two adjacent impact points are all equal to one another within ±15%.

## Patentansprüche

1. Elektronische Leiterplatte, die Folgendes umfasst:
- mindestens ein elektronisches Leistungsbauelement (6 bis 10), das mit einer Fußplatte (78) ausgestattet ist, die geeignet ist, direkt mit einem Wärmeträgerfluid in Berührung gebracht zu werden,
- eine Kühlplatte (4) auf der die Fußplatte (78) des elektronischen Leistungsbauelements auf dem Wärmeträgerfluid gegenüber dichte Weise befestigt ist, wobei diese Kühlplatte Folgendes umfasst:
. mindestens eine Aussparung (36, 38, 48, 50), von der eine Mündung unter der Fußplatte des elektronischen Leistungsbauelements (6 bis 10) mündet,
. mindestens eine Einlassöffnung (70) für das Wärmeträgerfluid im Inneren der Aussparung, und
. mindestens eine Auslassöffnung (70) für das Wärmeträgerfluid aus der Aussparung,
**dadurch gekennzeichnet, dass** die Kühlplatte (4) ferner Folgendes umfasst:
- eine Spritzplatte (42; 112), die zwischen der Einlassöffnung (70) und der Auslassöffnung (72) liegt, und
- mehrere gerade Düsen (86 bis 90; 114 bis 118), die diese Platte von einer Seite zur anderen entlang einer Spritzrichtung durchqueren, wobei die Länge der Düse entlang der Spritzrichtung größer oder gleich der größten Breite der Düse ist, die senkrecht zu dieser selben Richtung ist, um einen Wärmeträgerfluidstrahl (100 bis 104) entlang der Spritzrichtung zu bilden, wobei die Spritzrichtung jeder Düse einen Winkel α in Bezug zu einer Richtung bildet, die senkrecht zur Fußplatte ist, wobei der Winkel α zwischen -30 und + 30° enthalten ist.

2. Kohlplatte, die dazu bestimmt ist, elektronische Leistungsbauelemente zu tragen, die mit einer Fußplatte ausgestattet sind, die geeignet ist, direkt mit einem Wärmeträgerfluid in Berührung gebracht zu werden, wobei die Fußplatte dieser elektronischen Leistungsbauelemente auf dem Wärmeträgerfluid gegenüber dichte Weise auf der Kühlpatte befestigt ist, wobei diese Kühlplatte Folgendes umfasst:
. mindestens eine Aussparung (36, 38, 48, 50), von der eine Mündung unter der Fußplatte des elektronischen Leistungsbauelements (6 bis 10) mündet,
. mindestens eine Einlassoffnung (70) für das Wärmeträgerfluid im Inneren der Aussparung, und
. mindestens eine Auslassöffnung (72) für das Wärmeträgerfluid aus der Aussparung,
**dadurch gekennzeichnet, dass** die Kühlplatte (4) ferner Folgendes umfasst:
- eine Spritzplatte (42; 112), die zwischen der Einlassöffnung (70) und der Auslassöffnung (72) liegt, und
- mehrere gerade Düsen (86 bis 90; 114 bis 118), die diese Platte von einer Seite zur anderen entlang einer Spritzrichtung durchqueren, wobei die Länge der Düse entlang der Spritzrichtung größer oder gleich der größten Breite der Düse ist, die senkrecht zu dieser selben Richtung ist, um einen Wärmeträgerfluidstrahl (100 bis 104) entlang der Spritzrichtung zu bilden, wobei die Spritzrichtung jeder Düse einen Winkel α in Bezug zu einer Richtung bildet, die senkrecht zur Fußplatte ist, wobei der Winkel α zwischen -30 und + 30° enthalten ist.

3. Kohlplatte nach Anspruch 2, wobei die Düse (86 bis 90; 114 bis 118) durch ein Loch gebildet ist, das die Spritzplatte (42) durchquert.

4. Kühlplatte nach Anspruch 2 oder 3, wobei die Spritzplatte eben ist und wobei die Spritzrichtung jeder Düse senkrecht zu einer Vorder- (80) oder Rückseite (82) der Spritzplatte ist, wobei die Vorderseite der Spritzplatte diejenige ist, die der Fußplatte zugewandt ist, und die Rückseite die der Vorderseite entgegengesetzte Seite ist, und wobei die Spritzplatte (42) in einem Winkel β in Bezug zur Ebene der Fußplatte des elektronischen Leistungsbauelements geneigt ist, wobei der Winkel β zwischen -30 und +30° enthalten ist.

5. Kühlplatte nach einem der Ansprüche 2 bis 4, wobei die Kühlplatte Leitungen (56 bis 64) umfasst, die geeignet sind, um das Wärmeträgerflluid durch die Einlass- (70) und Auslassöffnungen (72) zum Umlaufen zu bringen, wobei diese Leitungen alle in einer selben Ebene angeordnet sind, die parallel zur durch die Fußplatte definierten Ebene ist.

6. Platte nach einem der Ansprüche 2 bis 5, wobei die Kühlplatte Folgendes umfasst:
. eine erste und eine zweite Aussparung (36, 38), wobei die erste und zweite Aussparung jeweils eine Mündung aufweisen, die unter der Fußplatte desselben ersten elektronischen Leistungsbauelements (6) münden,
. mindestens ein drittes Element (48, 50), das eine Mündung aufweist, die unter der Fußplatte eines zweiten elektronischen Leistungsbauelements (7) mündet,
. wobei die Auslassoffnung (72) der ersten Aussparung (36) über die Einlass— und Auslassöffnungen der dritten Aussparung (48, 50) fluidisch an die Einlassöffnung der zweiten Aussparung (38) angeschlossen ist.

7. Platte nach einem der Ansprüche 2 bis 6, wobei die Kühlplatte mindestens zehn Düsen (86 bis 90; 114 bis 118) umfasst, die in Bezug aufeinander angeordnet sind, um einförrnig über die Fußplatte verteilte Auftreffpunkte für die Wärmetragerfluidstrahlen (100 bis 104) zu erzeugen, das heißt, dass die Abstände zwischen zwei benachbarten Auftreffpunkten alle bis auf mehr oder weniger 15% gleich sind.
